Europäisches Patentamt

European Patent Office

Office européen des brevets

(11) Veröffentlichungsnummer: **0 375 997**
**A1**

(12) **EUROPÄISCHE PATENTANMELDUNG**

(21) Anmeldenummer: **89122290.3**

(22) Anmeldetag: **02.12.89**

(51) Int. Cl.5: **H01L 21/329**

(30) Priorität: **07.12.88 DE 3841149**

(43) Veröffentlichungstag der Anmeldung:
**04.07.90 Patentblatt 90/27**

(84) Benannte Vertragsstaaten:
**DE FR GB IT**

(71) Anmelder: **Asea Brown Boveri**
**Aktiengesellschaft**
**Kallstadter Strasse 1**
**D-6800 Mannheim 31(DE)**

(72) Erfinder: **Langer, Kurt, Dr.**
**Kiefernweg 8**
**D-6909 Walldorf(DE)**

(74) Vertreter: **Rupprecht, Klaus, Dipl.-Ing. et al**
**c/o Asea Brown Boveri Aktiengesellschaft**
**Zentralbereich Patente Postfach 100351**
**D-6800 Mannheim 1(DE)**

(54) Verfahren zur Herstellung einer Leistungshalbleiterdiode.

(57) Das Verfahren soll ohne die Verwendung von epitaktischem Material die Herstellung von Leistungshalbleiterdioden mit einer Basiszone bis herunter zu etwa 70 $\mu$m bei einer Scheibendicke von 200 $\mu$m ermöglichen.

Diese Aufgabe wird durch Kombination eines Verfahrens zur Herstellung einer isolationsdiffundierten Randzone und einem Verfahren zur Herstellung der erforderlichen p- und $n^+$-Schichten durch Tiefdiffusion gelöst, wobei unstrukturierte Dotierstoffquellen verwendet werden.

Das Verfahren läßt sich zur Herstellung von Leistungshalbleiterdioden verwenden, die schnell sind und eine Sperrspannung in Höhe der Volumendurchbruchspannung aufweisen.

Fig 1h

EP 0 375 997 A1

## Verfahren zur Herstellung einer Leistungshalbleiterdiode

Die Erfindung bezieht sich auf ein Verfahren zur Herstellung einer Silizium-Leistungshalbleiterdiode mit einer durch Isolationsdiffusion hergestellten Randzone.

Die Struktur der herzustellenden Diode ist beispielsweise aus IEEE Transactions on Electron Devices, Vol. ED-27, No. 1, January 1980, Seite 261 bis 265, Aufsatz von T. Tanaka, Y. Mochizuki, M. Okamura, "Analysis of a Junction Termination Structure for Ideal Breakdown Voltage in p-n Junction Devices", insbesondere Fig. 4 bekannt. Die dort dargestellte Diode ist aus einer n-dotierten Siliziumscheibe hergestellt, in die von der unteren Hauptfläche her ein Dotierstoff eindiffundiert ist zur Herstellung einer p-dotierten Schicht, wodurch ein sperrender pn-Übergang geschaffen ist. In der Randzone ist eine sogenannte Isolationsdiffusion durchgeführt, so daß der pn-Übergang nicht am Bauelementerand austritt, sondern umgelenkt wird zur oberen Hauptfläche. Dort endet der pn-Übergang in einem Graben, der mit einem Passivierungsglas abgedeckt ist. Nicht dargestellt, aber dem Fachmann geläufig, ist eine $n^+$-dotierte Schicht an der oberen Hauptfläche, die dann mit einer Kathodenmetallisierung versehen wird. Außerdem ist es dem Fachmann geläufig, die untere Hauptfläche mit einer Anodenmetallisierung zu versehen.

Bei solchen Leistungshalbleiterdioden, bei denen der Strom vertikal von einer Hauptfläche zur anderen Hauptfläche fließt, kann der Durchlaßspannungsabfall dadurch minimiert werden, daß die Dicke der Basiszone zwischen der $n^+$-dotierten Schicht und der p-dotierten Schicht der Raumladungszone angepaßt wird, die sich bei der gewünschten Sperrspannung einstellt. Soll das Bauelement aus homogen dotiertem Grundmaterial hergestellt werden, führt dies in gewissen Sperrspannungsbereichen zu der Forderung nach Scheibendicken unter 200 $\mu$m. Scheiben mit einer Dicke von weniger als 200 $\mu$m sind aber wegen einer erheblichen Bruchgefahr praktisch nicht mehr zu handhaben. Eine andere Möglichkeit eine dünne Basisschicht zu erreichen, besteht darin, extrem tiefe p- und $n^+$-Dotierungsprofile zu erzeugen. Solche tiefen p- und $n^+$-Dotierungsprofile sind mit üblichen Verfahren entweder nicht erreichbar oder nur mit kleinen Dotierungsgradienten in der Nähe des pn-Übergangs, die im Hinblick auf andere Eigenschaften unerwünscht sein können. Bei üblichen Verfahren werden die p- und $n^+$-Schichten dadurch hergestellt, daß auf den beiden Hauptflächen Dotierstoffquellen mit Hilfe von Masken strukturiert aufgebracht werden und eine sogenannte maskierte Tiefdiffusion durchgeführt wird. Deshalb werden Bauelemente im Spannungsbereich unter 1000V in der Regel auf Material hergestellt, das aus einem hochdotierten und relativ dicken Substrat mit einer niedrigdotierten epitaktischen Schicht geeigneter Dicke besteht. Vor allem bei einfachen Bauelementen kann sich diese Lösung aus Kostengründen verbieten, da das Grundmaterial ein wesentlicher Kostenfaktor sein kann.

Der Erfindung liegt die Aufgabe zugrunde, ein Verfahren anzugeben, mit dem einfach und kostengünstig isolationsdiffundierte Leistungsdioden hergestellt werden können, die ohne die Verwendung von epitaktischem Material Basiszonen bis herunter zu etwa 70 $\mu$m Dicke bei einer Scheibendicke von 200 $\mu$m aufweisen. Dabei sollen dennoch relativ steile Profile erzielt und eine Sperrspannung erreicht werden, die der Volumendurchbruchspannung entspricht.

Diese Aufgabe wird durch ein Verfahren gemäß dem Patentanspruch gelöst.

Obwohl im Patentanspruch zur Vereinfachung von einer n-dotierten Siliziumscheibe ausgegangen ist, ist die Erfindung selbstverständlich auch bei Verwendung einer p-dotierten Siliziumscheibe und entsprechend angepaßten Dotierstoffen durchführbar. Dem Fachmann ist auch geläufig, daß anstelle der genannten Dotierstoffe äquivalente Stoffe verwendet werden können.

Der Patentanspruch bezieht sich auf ein Verfahren zur Herstellung einer Leistungshalbleiterdiode mit einer durch eine Isolationsdiffusion hergestellten Randzone, bei der die erforderlichen Phosphor- bzw. Bor-dotierten kathoden- bzw. anodenseitigen Schichten nach einer unmaskierten Vorbelegung mit einer Tiefdiffusion hergestellt werden. Mit dieser Art der Schichtenherstellung werden sehr tiefe Profile ermöglicht, wobei der Dotierstoff wegen der hohen Oberflächenbelegung relativ weit in hoher Konzentration, d.h. etwa in Höhe der Sättigungskonzentration, eindringt. Dadurch erhält man trotz großer Eindringtiefe einen großen Dotierungsgradienten in der Nähe des pn-Übergangs. Außerdem ist eine unstrukturierte Belegung mit Dotierstoff kostengünstig.

Der Patentanspruch enthält zwei Verfahrensvarianten, wobei nach einer ersten Variante nur eine Tiefdiffusion erforderlich ist und somit vergleichsweise wenige Herstellschritte notwendig sind. Die Tiefdiffusion wird dabei bis zu der insgesamt benötigten Tiefe durchgeführt. Anschließend erfolgt die übliche Grabenätzung, womit erreicht wird, daß der sperrende pn-Übergang in einem Graben endet. Der Graben wird mit einer Passivierungsschicht abgedeckt und es wird auf der vorgesehenen Kathoden- bzw. Anodenfläche jeweils eine Metallschicht aufgebracht.

Nach einer zweiten Verfahrensvariante wird die Tiefdiffusion in zwei Schritten hergestellt, wobei nach der ersten Tiefdiffusion die Grabenätzung durchgeführt wird. In diesem Fall muß der Graben nicht so tief wie bei der ersten Verfahrensvariante geätzt werden, weil die dotierte Schicht nach dem ersten Diffusionsschritt noch nicht die volle erforderliche Schichtdicke erreicht hat.

Eine ausführliche Beschreibung des Herstellverfahrens erfolgt nachstehend anhand der Zeichnung.

Es zeigen:

Fig. 1a bis 1h Verfahrensschritte zur Herstellung einer Diode nach der zweiten Verfahrensvariante,

Fig. 2 Bor-Phosphor-Dotierungsprofil, das nach dem erfindungsgemäßen Verfahren erreicht werden kann.

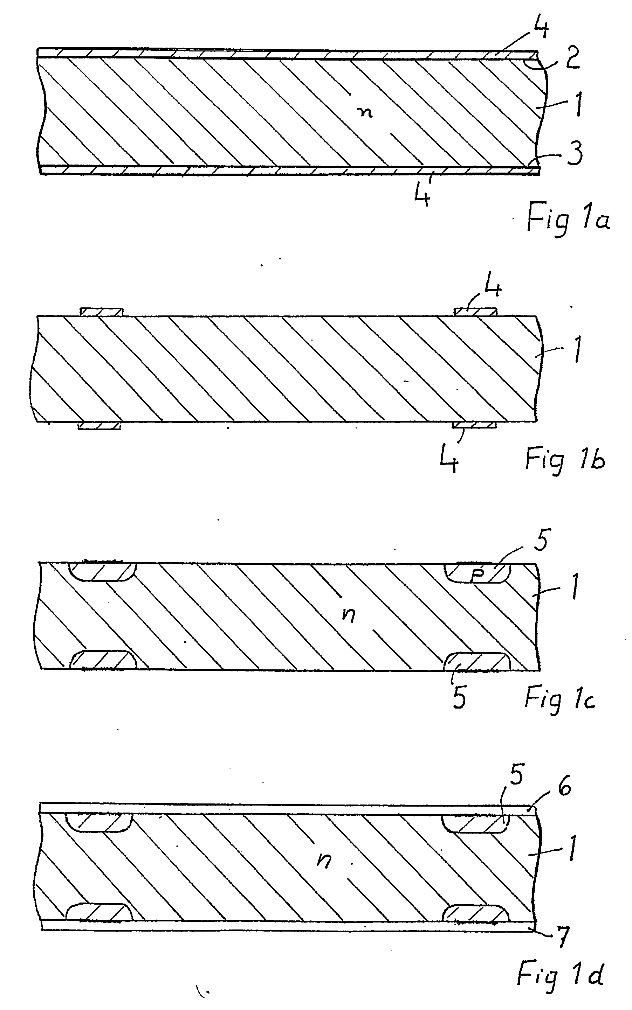

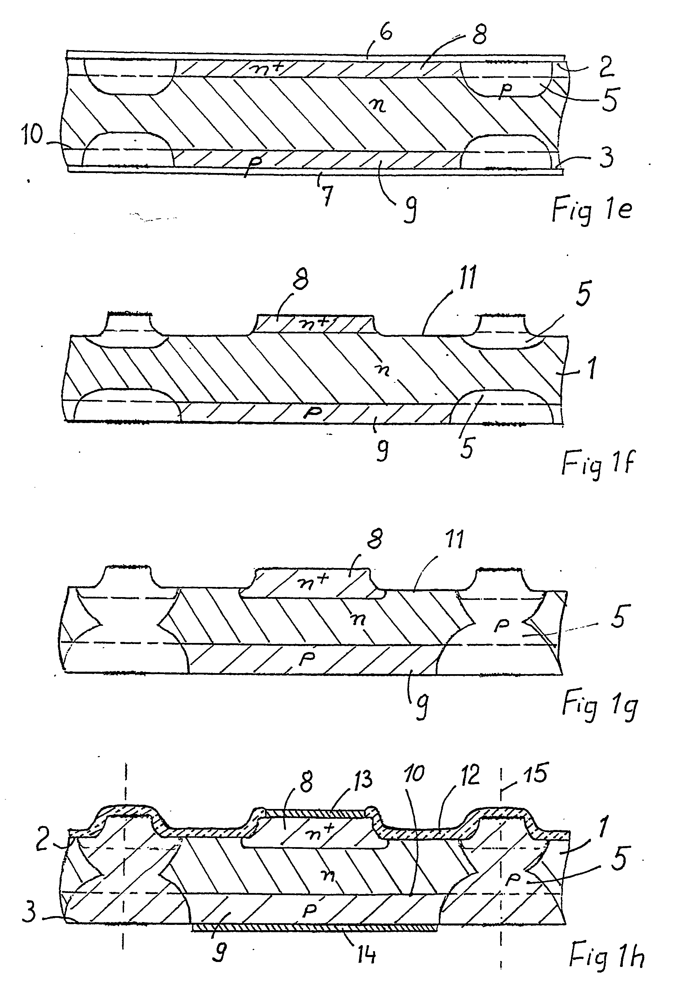

Fig. 1a zeigt eine n-dotierte Siliziumscheibe 1, die sowohl auf einer ersten Hauptfläche 2 und einer zweiten Hauptfläche 3 mit einer Aluminiumschicht 4 versehen ist. Diese Aluminiumschicht 4 wird anschließend auf bekannte Weise in einem Maskenprozeß strukturiert, so daß, wie in Fig. 1 dargestellt, die Aluminiumschicht nur in einem Randbereich der herzustellenden Diode als Aluminiumquelle für eine durch Diffusion herzustellende p-dotierte Randzone 5 (Fig. 1c bis Fig. 1h) übrig bleibt. Es ist darauf hinzuweisen, daß es sich bei den Fig. 1a bis 1h um Schnittbilder handelt und daß die in Fig. 1b dargestellten Schichten 4 in der Draufsicht jeweils als geschlossener Ring anzusehen sind.

Fig. 1c zeigt die Siliziumscheibe 1 nach einem ersten Diffusionsschritt, der als Trenndiffusion oder Isolationsdiffusion bekannt ist. Da noch zwei weitere Diffusionsschritte folgen, ist bei der ersten Diffusion die Diffusionszeit so gewählt, daß das Aluminium nur bis zu einer ersten Tiefe eindiffundiert. Diese erste Tiefe ist so gewählt, daß nach den beiden weiteren Diffusionsschritten eine durchgehende p-dotierte Randzone 5 entsteht. Reste der Aluminiumquelle werden entfernt.

Wie in Fig. 1d dargestellt, wird nachfolgend auf der ersten Hauptfläche ganzflächig ein erster Dotierstoff 6 aus Phosphor aufgebracht und auf der zweiten Hauptfläche 3 ein zweiter Dotierstoff 7 aus Bor. Das Ergebnis einer ersten simultanen Tiefdiffusion mit diesen Dotierstoffen ist in Fig. 1e dargestellt. Unter der ersten Hauptfläche 2 der Siliziumscheibe 1 ist eine $n^+$-dotierte Schicht 8 entstanden und unter der zweiten Hauptfläche eine p-dotierte Schicht 9. Außerdem ist der Dotierstoff Aluminium in der Randzone 5 tiefer in die Scheibe 1 eingedrungen. Reste der Dotierstoffquellen 6 und 7 werden entfernt.

Fig. 1f zeigt die Siliziumscheibe 1 nach einem weiteren Verfahrensschritt, in welchem ein Graben 11 nach bekannten ätztechnischen Verfahren hergestellt wird, der die im mittleren Bereich übrigbleibende $n^+$-dotierte Schicht 8, die einen Kathodenemitter bildet, umschließt. Die Tiefe des Grabens 11 ist etwas größer als die Dicke der $n^+$-Schicht 8.

Fig. 1g zeigt die Siliziumscheibe 1 nach einem zweiten simultanen Diffusionsschritt. Erst nach diesem Schritt ist die gewünschte Dicke der $n^+$-Schicht 8 und der p-dotierten Schicht 9 sowie eine durch die Scheibe 1 durchgehende Randzone 5 entstanden.

Fig. 1h zeigt die fertiggestellte Diode nach dem auf der als Kathodenemitter wirkenden $n^+$-dotierten Schicht 8 eine Kathodenmetallisierung 13 und auf der p-dotierten Schicht 9 eine Anodenmetallisierung 14 aufgebracht ist. Der Graben 11 und damit auch ein im Graben 11 an die Oberfläche tretender pn-Übergang 10 sind durch eine Passivierungsschicht 12 abgedeckt. Üblicherweise werden mit dem beschriebenen Verfahren mehrere Dioden gleichzeitig hergestellt, die durch Trennung der Siliziumscheibe 1 an der in Fig. 1h eingetragenen Trennlinie 15 in einzelne Diodenchips geteilt werden.

Zur Herstellung sogenannter schneller Dioden kann noch ein Prozeß zur Lebensdauereinstellung an geeigneter Stelle des vorbeschriebenen Herstellverfahrens eingefügt werden.

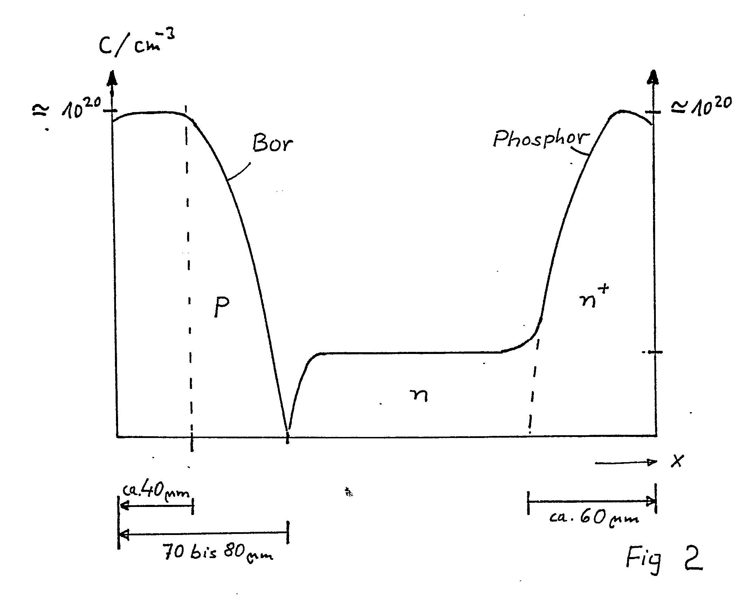

Fig. 2 zeigt ein Dotierungsprofil, das mit dem beschriebenen Herstellverfahren erzielbar ist. Dargestellt ist ein Profil, das bei einem Schnitt in einem mittleren Bereich der Diode gilt, wobei in der Abszisse die Eindringtiefe x der Dotierstoffe aufgetragen ist und in der Ordinate die Dotierstoffkonzentration C. Die Gesamtdicke der Diode beträgt im gewählten Beispiel etwa 230 $\mu$m. Die gezeigte Bor-Phosphor-Dotierungsprofile entstanden nach einer simulatenen Tiefdiffusion bei 1270°C und einer Dauer von 26 Stunden, wobei ein n-dotiertes Grundmaterial verwendet wurde.

Das im linken Bereich dargestellte Profil der p-dotierten Schicht 9 (Fig. 1h) zeigt, daß die Dotierstoffkonzentration C bis in eine Tiefe von etwa 40 $\mu$m praktisch konstant bleibt und dann relativ steil abfällt bis zu einer Eindringtiefe von etwa 70 bis 80 $\mu$m. Eine ähnliche Charakteristik zeigt das Phosphorprofil der $n^+$-Schicht 8, so daß eine relativ dünne Basiszone übrigbleibt.

## Ansprüche

Verfahren zur Herstellung einer Leistungshalbleiterdiode, die aus einer n-dotierten Siliziumscheibe (1) besteht, mit einer durch Isolationsdiffusion hergestellten p-dotierten Randzone (5) gekennzeichnet durch nachstehende Verfahrensschritte:

a) Aufbringen einer zur Herstellung der Randzone (5) strukturierten ersten Dotierstoffquelle aus Aluminium (4) auf einer ersten und einer zweiten Hauptfläche (2,3) der Siliziumscheibe (1),

b) Durchführung einer Aluminiumdiffusion bis zu einer ersten Tiefe, die so gewählt ist, daß erst nach dem als letzte Diffusion durchgeführten Diffussionsschritt eine vertikal durch die Scheibe (1) durchgehende p-dotierte Randzone (5) entsteht,

c) Aufbringen einer ersten unstrukturierten Dotierstoffquelle (6) aus Phosphor auf der ersten Hauptfläche (2) sowie einer zweiten unstrukturierten Dotierstoffquelle (7) aus Bor auf der zweiten Hauptfläche (3) und Durchführung einer simultanen Tiefdiffusion, wobei eine an die erste Hauptfläche (2) grenzende $n^+$-dotierte Schicht (8) entsteht und eine an die zweite Hauptfläche (3) grenzende p-dotierte Schicht (9),

d) Durchführung einer Grabenätzung zur Strukturierung der ersten Hauptfläche (2), wobei der hergestellte Graben (11) tiefer ist als die Dicke der im vorherigen Schritt hergestellten $n^+$-Schicht (8), und

e) entweder direkt daran anschließende Metallisierung der ersten Hauptfläche (2) zur Herstellung einer Kathodenmetallisierung (13) und der zweiten Hauptfläche (3) zur Herstellung einer Anodenmetallisierung (14) sowie Abdeckung des Grabens (11) mit einer Passivierungsschicht (12) oder zuvor Durchführung einer zweiten simultanen Diffusion.

4

Fig 1a

Fig 1b

Fig 1c

Fig 1d

Fig 1e

Fig 1f

Fig 1g

Fig 1h

Fig 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | FR-A-2 333 350 (GENERAL ELECTRIC CO.) * Figuren * --- | 1 | H 01 L 21/329 |
| A | EP-A-0 217 780 (GENERAL INSTRUMENT CORP.) * Figuren * --- | 1 | |
| D,A | IEEE TRANSACTIONS ON ELECTRON DEVICES, Band ED-27, Nr. 1, Januar 1980, Seiten 261-265, IEEE Inc., New York, US; T. TANAKA et al.: "Analysis of a junction termination structure for ideal breakdown voltage in p-n junction devices" * Figur 4 * ----- | 1 | |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| DEN HAAG | 03-04-1990 | GELEBART J.F.M. |